# FASCICULE DE BREVET EUROPEEN

(11) **EP 0 929 147 B1**
(45) Date de publication et mention de la délivrance du brevet: **26.05.2010**
(21) Numéro de dépôt: 98403329.0
(22) Date de dépôt: 30.12.1998
(51) Int. Cl.: H03F 1/32

(54) **Dispositif de contrôle en amplitude et en phase d'un signal radiofréquence**
Amplituden- und Phasensteuerungsvorrichtung eines Hochfrequenzsignals
Amplitude and phase control device of a radio frequency signal

(30) Priorité: 06.01.1998 FR 9800032
(43) Date de publication de la demande: 14.07.1999
(73) Titulaire: Alcatel Lucent, 75008 Paris (FR)
(72) Inventeur: Cazaux, Jean Louis, 31100 Toulouse (FR); Barbaste, Régis, 31810 Venerque (FR); Cogo, Bernard, 31850 Montrabe (FR)
(74) Mandataire: Smith, Bradford Lee

(56) Documents cités:
- EP-A- 0 658 975
- EP-A- 0 675 594
- EP-A- 0 682 406
- IMAI N ET AL: "NOVEL LINEARIZER USING BALANCED CIRCULATORS AND ITS APPLICATION TO MULTILEVEL DIGITAL RADIO SYSTEMS" IEEE TRANSACTIONS ON MICROWAVE THEORY AND TECHNIQUES, vol. 37, no. 8, août 1989, pages 1237-1243, XP000038624

## Description

L'invention concerne un dispositif de contrôle numérique en amplitude et en phase d'un signal radiofréquence, un linéariseur à pré-distortion comportant au moins un tel dispositif ainsi qu'un procédé de contrôle numérique en amplitude et en phase d'un signal radiofréquence.

L'invention s'applique notamment, mais de manière non limitative, aux linéariseurs à prè-distortion à haute fréquence utilisés en amont des tubes à ondes progressives (TOP) ou des amplificateurs à état solide (SSPA en anglais - Solid State Power Amplifier), pour les linéariser.

L'utilisation d'un linéariseur est rendue nécessaire par le fait bien connu de l'homme de l'art, que pour obtenir un bon rendement électrique d'un amplificateur, en particulier d'un amplificateur de puissance, celui-ci doit fonctionner près de la saturation. Or, près de ce point de fonctionnement, la linéarité de l'amplificateur est fortement dégradée par rapport à la linéarité de ce même amplificateur utilisé avec des signaux d'amplitude plus faibles que ceux nécessaires pour amener celui-ci en régime de saturation.

Afin d'accroître la dynamique en régime linéaire d'un amplificateur, sans sacrifier le rendement électrique obtenu près de la saturation, il est connu d'utiliser un dispositif de correction de non-linéarités.

En hyperfréquence, on préfère l'utilisation d'un linéariseur à prédistorsion. Le principe repose sur l'extraction va un coupleur, d'une partie du signal avant l'amplification de celui-ci, qui est ensuite traitée par différents composants électroniques actifs et passifs pour obtenir un signal non-linéaire de correction, ayant les mêmes caractéristiques de non-linéarité que celles du signal utile à corriger, mais en opposition de phase. Le linéariseur à prédistorsion fourni un signal de correction avec le signal à amplifier à l'entrée de l'amplificateur hyperfréquence de puissance dont on voudrait corriger les non-linéarités.

Classiquement, ces linéariseurs à pré-distortion comportent une voie dite linéaire comportant un amplificateur fonctionnant à faibles signaux et une voie dite non-linéaire comportant un amplificateur générateur d'une distortion non-linéaire de même amplitude que celle de l'amplificateur de puissance à linéariser.

Pour ces linéariseurs, il est nécessaire de prévoir un ajustement de la différence de phase et de la différence d'amplitude des signaux qui se propagent dans les deux voies.

Le bon fonctionnement du linéariseur, c'est à dire l'obtention d'une bonne pré-distortion est conditionnée par un contrôle très fin de ces différences d'amplitude et de phase;

Ce contrôle en amplitude et en phase est effectué à l'aide de circuits de contrôle analogiques ou numériques.

Le document EP-A-0682406 décrit un linéariseur à pré-distortion large bande et auto compensé en température pour amplificateur H.F.

Les circuits de contrôle analogiques permettent d'obtenir une grande précision, de l'ordre de 1 degrés en phase et de 0,1 d8 en amplitude. Cependant ils présentent les inconvénients usuels de l'analogique, notamment ils sont particulièremént sensibles aux variations de température, de niveau de puissance incidente, de tension de commande et ne permettent pas une automatisation des opérations de mise au point et des mesures.

En outre, dans la plupart des applications, les circuits aval ou amont sont des circuits numériques, de sorte qu'il est nécessaire de prévoir un convertisseur analogique/numérique pour la liaison.

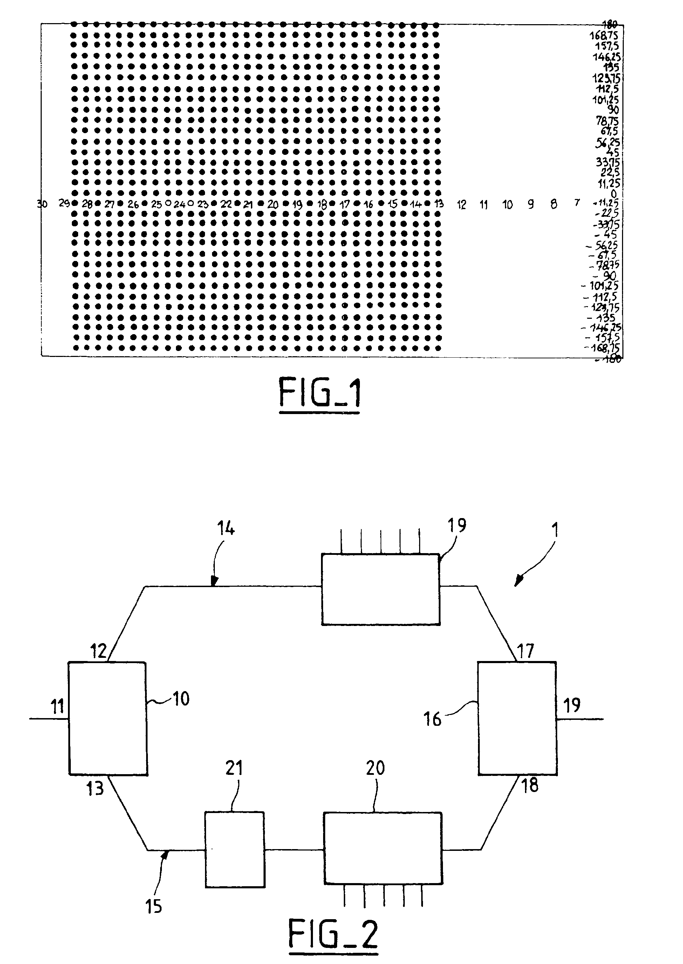

S'agissant des circuits de contrôle numériques, il est connu d'utiliser un déphaseur numérique variable pour le contrôle de phase, branché en série avec un atténuateur numérique variable pour le contrôle d'amplitude. Ainsi, dans le cas des linéariseurs à prè-distortion, l'association d'un déphaseur M bits réalisant la couverture complète du plan de phase (360°) et d'un atténuateur N bits ayant une dynamique de contrôle d'amplitude sur A dB permet d'obtenir une couverture totale de 360° de phase et A dB d'amplitude avec une révolution de 360°/2^{M} en phase et A/2^{N} dB en amplitude. Le nombre d'états de contrôle obtenu sur un plan amplitude-phase est de 2^{M+N} uniformément répartie. La figure 1 montre une telle répartition dans le cas où M = N = 5.

Cependant la précision du contrôle est limitée, car liée directement à la valeur des bits de plus faible poids des atténuateur et déphaseur qu'il est possible d'atteindre.

Par exemple, dans le cas des déphaseurs numériques usuels 6 bits réalisant une couverture complète du plan de phase (360°), la précision la plus fine qui peut être obtenue est de 5,625 degrés. De même, dans le cas des atténuateurs numériques usuels 6 bits ayant une dynamique de contrôle d'amplitude sur 32 dB, la précision la plus fine qui peut être obtenue est de 0,5 dB.

Pour améliorer cette précision du contrôle, on pourrait envisager d'augmenter le nombre de bits disponibles en divisant la valeur du bit de poids le plus faible. Par exemple, un déphaseur 8 bits disposerait d'une précision quatre fois meilleure qu'un déphaseur 6 bit. Cependant les moyens techniques actuellement disponibles, notamment dans le domaine des hyperfréquences, ne permettent pas de réaliser, de manière reproductible, des circuits numériques comportant le nombre de bit suffisant pour obtenir cette précision.

En outre, dans le cas d'une réalisation spécifique d'un tel circuit, le coût à prévoir est prohibitif.

L'invention vise donc à palier les inconvénients précédemment mentionnés.

Elle a pour objet un dispositif et un procédé de contrôle d'un signal radiofréquence fournissant une précision au moins équivalente à celle que procurent les circuits analogiques tout en profitant des avantages du numérique, tels que notamment :
- stabilité en température;
- fonctionnement sur une large plage de fréquence;
- très faible sensibilité aux variations indésirables des tensions de commande, dues par exemple au vieillissement ou aux perturbations électromagnétiques;
- automatisation simple des opérations de mise au point et de mesure.

A cet effet, selon un premier aspect, l'invention propose un dispositif de contrôle numérique en amplitude et en phase d'un signal radiofréquence, comportant :
- des moyens de répartition, ayant une entrée et deux sorties et permettant de répartir le signal de radiofréquence en une première et une deuxième parties de signal,
- une première voie de contrôle numérique en amplitude reliée à une sortie des moyens de répartition et comportant un atténuateur numérique variable permettant de contrôler en amplitude une première partie de signal;
- une deuxième voie de contrôle numérique en phase reliée à l'autre sortie des moyens de répartition en paralléle à la première voie de contrôle numérique et comportant un déphaseur numérique variable permettant de contrôler en phase une deuxième partie de signal ; et
- des moyens de recombinaison ayant une sortie et deux entrées reliés aux sorties des deux voies de contrôle numérique et permettant de recombiner les deux parties de signal contrôlées.

Les contributions respectives des deux parties de signal traversant l'une et l'autre voie de contrôle numérique permettent d'obtenir une couverture beaucoup plus réduite en phase et en amplitude tout en conservant un nombre d'état identique à la configuration série de l'art antérieur. On obtient ainsi une meilleure précision de l'ordre de 2 degrés en phase et 0,25 dB en amplitude, sans avoir à modifier les circuits numériques existant sur le marché.

En outre, les pertes d'insertion global amenées par un tel dispositif sont inférieures à celles qui sont obtenues avec les dispositifs de l'art antérieur.

Selon un mode de réalisation, le dispositif de contrôle numérique comporte, en outre, des moyens d'atténuation, tels que par exemple un atténuateur fixe, montés en série sur l'une au moins des voies de contrôle numérique et destinés à ajuster l'écart entre les pertes d'insertion respectives de l'atténuateur numérique variable et du déphaseur numérique variable.

Selon un deuxième aspect, l'invention propose un linéariseur à prédistortion comportant :
- une voie linéaire et une voie non-linéaire reliées en parallèle d'une part en entrée à un coupleur d'entrée et d'autre part en sortie à un coupleur de sortie, et
- au moins un dispositif de contrôle numérique selon l'invention, monté en série sur l'une des voies du linéariseur.

L'utilisation d'un dispositif de contrôle selon l'invention permet de contrôler très précisément gain et phase des voies linéaire et non-linéaire pour assurer un bon fonctionnement du linéariseur, tout en profitant des avantages du numérique.

Selon un troisième aspect, l'invention propose un procédé de contrôle numérique en amplitude et en phase d'un signal radiofréquence, qui comporte les étapes de :
a) répartition du signal radiofréquence en une première et une deuxième parties de signal;
b) contrôle numérique en amplitude de la première ou deuxième partie de signal;
c) contrôle numérique en phase de la deuxième, respectivement première, partie de signal;
d) recombinaison des deux parties de signal contrôlées pour former un signal radiofrèquence contrôlé en phase et en amplitude.

Selon une autre caractéristique, les étapes b) et c) sont effectuées simultanément.

En outre, le signal radiofréquence peut être réparti en deux parties de signal identiques.

D'autres caractéristiques de l'invention sont explicitées de manière non limitative dans la description qui suit de modes de réalisation, en référence aux figures annexées.
La figure 1 est une représentation dans un plan phase-amplitude de la répartition du nombre d'états de contrôle obtenue avec une configuration série de l'art antérieur.
La figure 2 est un schéma bloc d'un dispositif de contrôle selon l'invention.
La figure 3 est une représentation dans un plan phase-amplitude de la répartition du nombre d'états de contrôle obtenue par simulation d'un dispositif de contrôle selon l'invention, sans atténuateur fixe.
La figure 4 est une représentation dans un plan phase-amplitude de la répartition du nombre d'états de contrôle obtenue par simulation d'un dispositif de contrôle selon l'invention, avec un atténuateur fixe de -3 dB monté sur la voie deuxième voie.
La figure 5 est une représentation dans un plan phase-amplitude de la répartition du nombre d'états de contrôle obtenue par simulation d'un dispositif de contrôle selon l'invention, avec atténuateur fixe de +3dB monté sur la première voie.
La figure 6 est un schéma bloc d'un premier mode de réalisation d'un linéariseur selon l'invention.
La figure 7 est un schéma bloc d'un deuxième mode de réalisation d'un linéariseur selon l'invention.

Le dispositif de contrôle décrit dans ce qui suit est utilisé dans le cadre d'une application aux signaux hyperfréquence. Cependant l'invention n'est pas limitée à ce domaine de fréquence et peut être appliquée d'une manière générale à tout signal radiofréquence.

Le dispositif de contrôle 1 représenté à la figure 2 comporte un répartiteur 10, tels que par exemple un coupleur hybride, à une entrée 11 et deux sorties 12 et 13, deux voies de contrôle numérique 14 et 15 et un recombineur 16, tel qu'un coupleur hybride, à deux entrées 17 et 18 et une sortie 19.

Les deux voies de contrôle 14 et 15 sont reliées parallèlement respectivement entre les sorties 12 et 13 du répartiteur 10 et les entrées 17 et 18 du recombineur 16. La première voie 14 est une voie de contrôle en amplitude. Elle comporte un atténuateur numérique variable N bits 19 ayant une dynamique de contrôle en amplitude sur A dB et présentant des pertes d'insertion de n dB. La deuxième voie 15 est une voie de contrôle en phase. Elle comporte un déphaseur numérique variable M bits 20 réalisant la couverture complète du plan de phase, soit 360 degrés, et présentant des pertes d'insertion de m dB. Généralement m est supérieur à n.

Le répartiteur 10 reçoit, par son entrée 11 le signal à contrôler et le répartit en deux parties de signal. Dans l'exemple de réalisation décrit, ces deux parties de signal sont identiques. Bien entendu elles peuvent être différentes. Une première partie de signal est transmise et contrôlée dans la voie de contrôle en amplitude 14 et une deuxième partie de signal, dans la voie de contrôle en phase 15. Les deux parties de signal contrôlées respectivement en amplitude et en phase sont recombinées dans le recombineur 16 qui effectue une somme vectorielle.

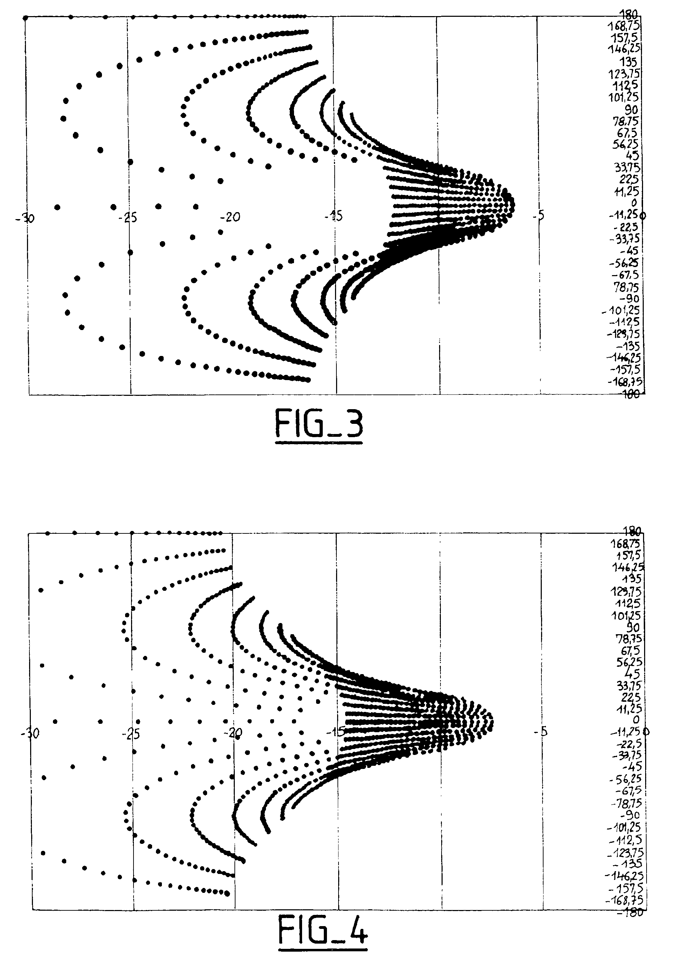

Le nombre d'états de contrôle reste inchangé par rapport à celui de l'art antérieur puisque les circuits numériques ne sont pas modifiés mais ces états de contrôle sont répartis sur une couverture totale plus réduite, du fait du contrôle en phase et en amplitude sur une partie seulement du signal. Par conséquent, sur cette couverture totale réduite, la précision est meilleure. Un exemple de répartition obtenu par simulation est représenté à la figure 3 pour M=N=5, n=-5 dB et m =-8dB.

Nous verrons dans la suite de la description que, pour les applications concernées par l'invention, cette réduction de la couverture totale de contrôle en phase et amplitude n'est pas limitative puisque le contrôle est effectué sur une échelle de quelques degrés et quelques dB.

La couverture totale peut être modifiée en amplitude, en modifiant l'écart des pertes d'insertion des deux voies de contrôle.

A cet effet, dans un mode de réalisation de l'invention, le dispositif de contrôle 1 comporte en outre un atténuateur fixe 21 branché en série sur l'une quelconque des voies de contrôle et destiné à régler l'écart des pertes d'insertion entre les deux voies.

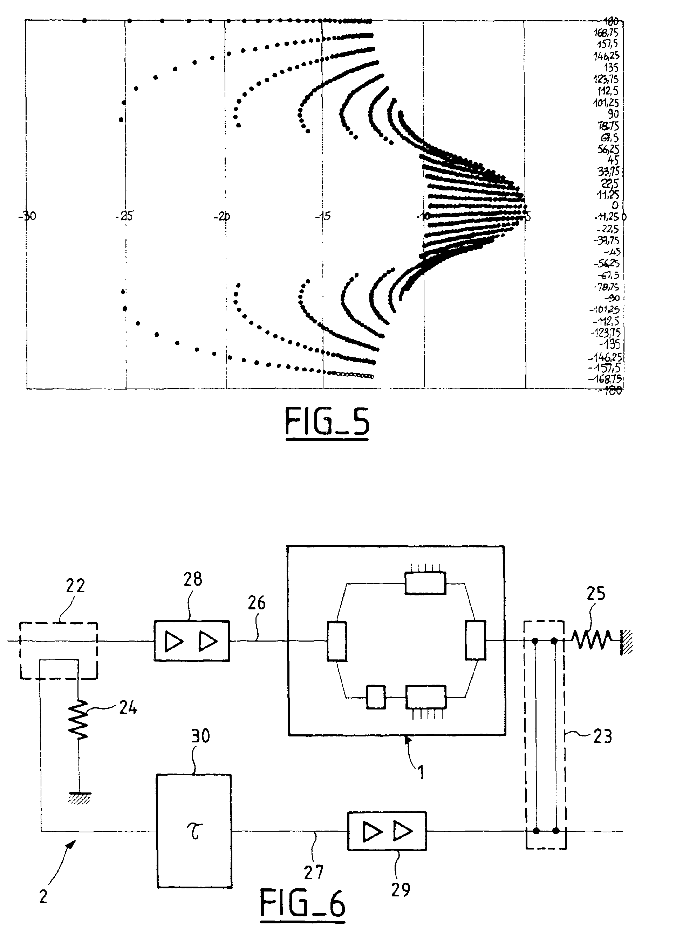

Suivant un mode de mise en oeuvre préféré de l'invention, comme représenté à la figure 2, l'atténuateur fixe 21 est branché sur la voie de contrôle en phase 15, en série et en amont du déphaseur 20. Des exemples de répartition des états de contrôle obtenus par simulation sont représentés aux figures 4 et 5 pour des atténuateurs fixes de -3 dB montés sur la voie de contrôle en phase 15 et la voie de contrôle en amplitude 14 respectivement.

Le dispositif de contrôle 1 selon l'invention est destiné à faire partie d'un linéariseur à pré-distorsion dont il améliore la précision de contrôle en amplitude et en phase.

A cet effet, l'invention propose en outre un linéariseur comportant au moins un dispositif de contrôle du type décrit précédemment.

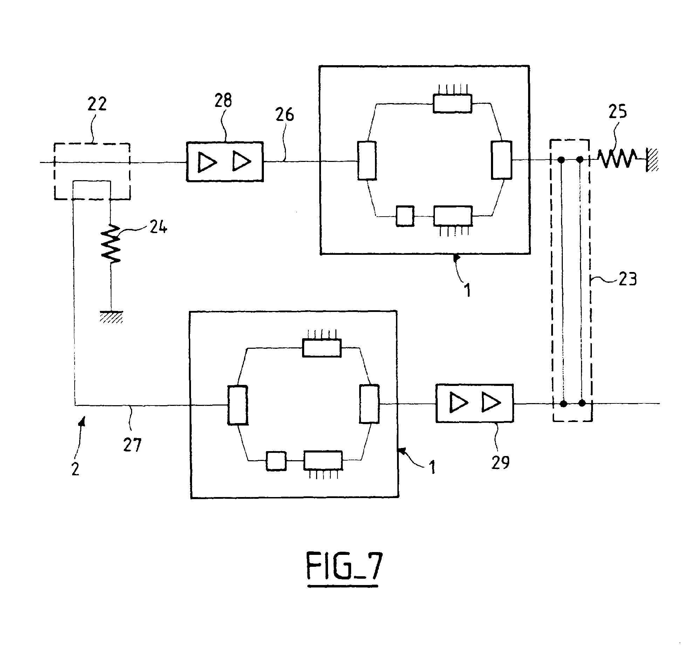

Le linéariseur à pré-distorsion 2 des figures 6 et 7 est destiné à être directement placé en amont d'un amplificateur de puissance (non représenté) pour assurer simultanément une distorsion en amplitude et en phase du signal qui lui est appliqué, ces distortions étant complémentaires de celles générées par l'amplificateur de puissance, de manière à compenser ces dernières.

Dans les exemples représentés, le linéariseur à pré-distortion comporte deux coupleurs hybrides 22 et 23, terminés par des charges adaptées respectivement 24 et 25, et deux lignes de transmission 26 et 27 dites voie non-linéaire 26 et voie linéaire 27.

Le signal à amplifier est présenté à l'entrée E du linéariseur, d'où il est appliqué à l'entrée du coupleur 22. Le signal est ainsi divisé en deux parties, qui sont appliquées respectivement aux entrées de deux lignes de transmission 26 et 27. Classiquement, le coupleur 22 introduit un décalage de phase entre les deux signaux fournis en sortie vers les deux lignes de transmission. Ce coupleur 22 peut être par exemple un coupleur hybride 10 dB, qui introduit un déphasage de 90°.

La voie non-linéaire 26 comporte un amplificateur 28, générateur d'une distorion non-linéaire d'amplitude de même nature que celle de l'amplificateur de puissance à linéariser et la voie linéaire 27 comporte un amplificateur 29 fonctionnant à faibles signaux.

Selon l'invention, le linéariseur 2 comporte, en outre, un dispositif de contrôle 1 monté sur l'une des voies 26 ou 27 du linéariseur et de préférence sur la voie non-linéaire 26, comme représenté à la figure 6. Dans ce mode de réalisation, le dispositif de contrôle 1 est branché en série et en aval de l'amplificateur 28.

Les signaux sur les deux voies sont ensuite additionnés par le coupleur 23. Le signal de correction par prédistorsion est fourni en sortie S du coupleur 23 à un amplificateur hyperfréquence de puissance (non représenté). Classiquement, le coupleur 23 introduit un décalage de phase entre les deux signaux fournis sur ses entrées par les deux lignes de transmission 26 et 27, avant leur sommation. Ce coupleur 23 peut être par exemple un coupleur hybride 3dB qui introduit un déphasage de 90°.

Suivant un mode de réalisation, il est préférable de prévoir des longueurs électriques identiques des deux voies de manière à rendre la fonction de transfert du linéariseur sensiblement indépendante de la fréquence pour que ce dernier puisse fonctionner sur une très large bande de fréquence.

A cet effet suivant un premier mode de mise en oeuvre, le linéariseur 2 comporte un deuxième dispositif de contrôle 1, tel que représenté à la figure 7, branché sur la voie linéaire 27 en série et en amont de l'amplificateur 29, pour équilibrer les temps de groupe des deux voies 26 et 27.

Bien entendu, on peut prévoir d'effectuer un contrôle différent sur chacune des voies du linéariseur ou encore un contrôle sur l'une seulement des voies. Dans ce dernier cas, le dispositif de contrôle de l'autre voie n'est présent que pour équilibrer les temps de groupe des deux voies et est inactif c'est à dire qu'il n'applique aucun contrôle de la partie de signal passant dans ladite voie.

Suivant un autre mode de mise en oeuvre, représenté à la figure 6, le deuxième dispositif de contrôle est remplacé par une ligne à retard 30.

Le linéariseur décrit ci-dessus à l'aide des figures 6 et 7 présente donc un déphasage prédéterminé de 180° entre les deux voies, ce déphasage prédéterminé résultant uniquement des déphasages introduits par les deux coupleurs 22 et 23.

Or, comme il est connu de l'homme du métier, le déphasage relatif Δ ϕ des signaux sur la voie linéaire et la voie non-linéaire d'un linéariseur permettant d'obtenir une fonction de transfert globale correspondant à un tube à ondes progressives comme amplificateur hyperfréquence de puissance, est de l'ordre de Δ ϕ ≈ - 170°, avec une différence d'amplitude sur les deux voies de l'ordre de 3dB. Pour un amplificateur hyperfréquence de puissance à l'état solide, en revanche, le déphasage relatif des signaux sur les deux voies est de l'ordre de Δ ϕ ≈ + 170°.

Dans cette réalisation, on constate donc que les deux voies sont naturellement réglées très proche du point optimum, défini par : Δ ϕ ≈ ± 170°, Δ *V* ≈ 3*dB*. L'ajustage final, qu'il reste à effectuer de la différence de phase ou de la différence de l'amplitude des signaux qui se propagent dans les deux voies linéaire et non linéaire, doit donc être effectué par le dispositif de contrôle 1 sur une échelle de quelques degrés et quelques dB.

Par conséquent la couverture totale de contrôle obtenue à l'aide du dispositif de contrôle selon l'invention, bien que réduite, est tout à fait adaptée.

Les circuits qui constituent le dispositif de contrôle et le linéariseur selon l'invention peuvent être réalisés selon les techniques habituelles de l'homme du métier, et en particulier par les technologies MMIC ou MIC. Les circuits peuvent être réalisés collectivement ou individuellement, et ensuite reliés par des circuits microruban, ou par des techniques hybrides.

Enfin, l'invention concerne un procédé de contrôle numérique en amplitude et en phase d'un signal radiofréquence mis en oeuvre à l'aide d'un dispositif de contrôle tel que décrit précédemment.

Comme il découle de la description ci-dessus, le procédé comporte les étapes de :
a) répartition du signal radiofréquence en une première et une deuxième parties de signal;
b) contrôle numérique en amplitude de la première ou deuxième partie de signal;
c) contrôle numérique en phase de la deuxième, respectivement première, partie de signal;
d) recombinaison des deux parties de signal contrôlées pour former un signal radiofréquence contrôlé en phase et en amplitude.

Suivant le mode de réalisation décrit précédemment, le signal radiofréquence est réparti en deux parties de signal identiques, et les étapes b) et c) sont effectuées simultanément.

Il est également prévu une étape consistant à équilibrer les pertes d'insertions qui sont intervenues au cours des étapes b) et c).

En outre, l'étape d) est une addition vectorielle des deux parties de signal contrôlées.

Bien entendu, l'invention n'est pas limitée aux exemples décrits précédemment, mais peut s'appliquer à d'autres réalisations telles que par exemple le contrôle des antennes actives à balayage, ou encore à toute réalisation utilisant un ou plusieurs moyen(s) équivalent(s) aux moyens décrits, pour remplir les mêmes fonctions, en vu d'obtenir les mêmes résultats.

D'une manière plus générale, l'invention concerne toute application nécessitant un contrôle numérique précis d'une fonction de transfert phase/amplitude.

## Revendications

1. Dispositif de contrôle numérique en amplitude et en phase d'un signal radiofréquence, comportant un atténuateur numérique variable et un déphaseur numérique variable, **caractérisé en qu'**il comporte, en outre :
- des moyens de répartition (10), ayant une entrée (11) et deux sorties (12, 13) et permettant de répartir le signal radiofréquence en une première et une deuxième parties de signal,
- une première voie de contrôle numérique en amplitude (14) reliée à une sortie (12) des moyens de répartition (10) et comportant l'atténuateur numérique variable (19) permettant de contrôler en amplitude la première partie de signal :
- une deuxième voie de contrôle numérique en phase (15) reliée à l'autre sortie (13) des moyens de répartition (10) en parallèle à la première voie de contrôle numérique (14) et comportant le déphaseur numérique variable (20) permettant de contrôleur en phase la deuxième partie de signal; et
- des moyens de recombinaison (16), ayant une sortie (19) et deux entrées (17, 18) reliées respectivement aux sorties des deux voies de contrôle numérique (14. 15) et permettant de recombiner les deux parties de signal contrôlées,
et en ce que les moyens de répartition comportent un répartiteur (10) permettant de diviser le signal radiofréquence en deux parties de signal identiques.

2. Dispositif de contrôle numérique selon la revendication 1, **caractérisé en ce qu'**il comporte, en outre, des moyens d'atténuation (21), branchés en série sur l'une au moins des voies de contrôle numérique (14, 15) et destiné à ajuster l'écart entre les pertes d'insertion respectives de l'atténuateur numérique variable (19) et du déphaseur numérique variable (20).

3. Dispositif de contrôle numérique selon la revendication 2, **caracterisé en ce que** les moyens d'atténuation (21) sont montés sur la première voie de contrôle numérique (14), en amont du déphaseur numérique variable (20).

4. Dispositif de contôle numérique selon la revendication 2 ou 3, **caractérisé en ce que** les moyens d'atténuation comportent un atténuateur fixe

5. Linéariseur à pré-distortion comportant une voie linéaire (27) et une voie non-linéaire (26) reliées en parallèle d'une part en entrée à un coupleur d'entrée (22) et d'autre part en sortie à un coupleur de sortie (23), **caractérisé en ce qu'**il comporte au moins un dispositif de contrôle numérique (1) selon l'une quelconque des revendications 1 à 5 monté en série sur l'une des voies (26 ou 27) du linéariseur.

6. Linéariseur à pré-distortion selon la revendication 5, **caractérisé en ce que** le dispositif de contrôle numérique (1) est monté sur la voie non-linéaire (26).

7. Linéariseur à pré-distortion selon la revendication 5 ou 6, **caractérisé en ce qu'**il comporte, en outre, une ligne à retard (30) montée en série sur l'autre voie.

8. Linéariseur à pré-distortion selon la revendication 5, **caractérisé en ce qu'**il comporte deux dispositifs de contrôle numérique (1) selon l'une quelconque des revendications 1 à 6 montés en série respectivement sur chaque voie du linéariseur, l'un des dispositifs étant destiné à équilibrer les temps de groupe des deux voies du linéariseur.

9. Procédé de contrôle numériques en amplitude et en phase d'un signal radiofréquence, **caractérisé en ce qu'**il comporte les étapes de :
a) répartition du signal radiofréquence en une première et une deuxième parties de signal;
b) contrôle numérique en amplitude de la première ou deuxième partie de signal ;
c) contrôle numérique en phase de la deuxième, respectivement première, partie de signal ;
d) recombinaison des deux parties de signal contrôlées pour forcer un signal radiofréquence contrôlé en phase et en amplitude,
et **en ce que** le signal radiofréquence est reparti en deux parties de signal identiques.

10. Procédé selon la revendication 3, **caractérisé en ce** les étapes b) et c) sont effectuées simultanément.

11. Procédé selon l'une quelconque des revendication 9 à 10, **caractérisé en ce qu'**il comporte, en outre, une étape consistant à équilibrer les pertes d'insertions qui sont intervenues au cours des étapes b) et c).

12. Procédé selon l'une quelconque des revendications 9 à 11, **caractérisé en ce que** le signal radiofréquence est un signal hyperfréquence.

## Claims

1. Phase and amplitude digital control device for a radio frequency signal, comprising a variable digital attenuator and a variable digital phase shifter, **characterized in that** it also comprises:
- distribution means (10), with one input (11) and two outputs (12, 13) and used to divide the radio frequency signal into first and second signal parts,
- a first amplitude digital control channel (14) connected to an output (12) of the distribution means (10) and comprising the variable digital attenuator (19) used to control the amplitude of the first signal part
- a second phase digital control channel (15) connected to the other output (13) of the distribution means (10) in parallel with the first digital control channel (14) and comprising the variable digital phase shifter (20) used to control the phase of the second signal part; and
- recombining means (16), with one output (19) and two inputs (17, 18) connected respectively to the outputs of the two digital control channels (14, 15) and used to recombine the two controlled signal parts,
and **in that** the distribution means include a splitter (10) used to divide the radio frequency signal into two identical signal parts.

2. Digital control device according to claim 1 **characterized in that** it also comprises attenuation means (21), connected in series on at least one of the digital control channels (14, 15) and intended to adjust the difference between the respective insertion losses of the variable digital attenuator (19) and the variable digital phase shifter (20).

3. Digital control device according to claim 2, **characterized in that** the attenuation means (21) are mounted on the first digital control channel (14), upstream of the variable digital phase shifter (20).

4. Digital control device according to claim 2 or 3, **characterized in that** the attenuation means comprise a fixed attenuator (21).

5. Predistortion linearizer comprising a linear channel (27) and a non-linear channel (26) connected in parallel on the one hand at the input to an input coupler (22) and on the other hand at the output to an output coupler (23), **characterized in that** it comprises at least one digital control device (1) according to any of claims 1 to 5 mounted in series on one of the channels (26 or 27) of the linearizer.

6. Predistortion linearizer according to claim 5, **characterized in that** the digital control device (1) is mounted on the non-linear channel (26).

7. Predistortion linearizer according to claim 5 or 6, **characterized in that** it also comprises a delay line (30) mounted in series on the other channel.

8. Predistortion linearizer according to claim 5, **characterized in that** it comprises two digital control devices (1) according to any of claims 1 to 6, mounted in series respectively on each channel of the linearizer, one of the devices being intended to balance the group times of the two channels of the linearizer.

9. Amplitude and phase digital control method of a radio frequency signal, **characterized in that** it comprises the following stages:
a) distribution of the radio frequency signal into a first and second signal part;
b) amplitude digital control of the first or second signal part;
c) phase digital control of the second, or first respectively, signal part;
d) recombining of the two controlled signal parts to form a radio frequency signal controlled in terms of phase and amplitude,
and **in that** the radio frequency signal is distributed in two identical signal parts.

10. Method according to claim 9, **characterized in that** stages b) and c) are carried out simultaneously.

11. Method according to either of claims 9 or 10, **characterized in that** it also comprises a stage involving balancing the insertion losses which occur during stages b) and c).

12. Method according to any of claims 9 to 11, **characterized in that** the radio frequency signal is a hyperfrequency signal.

## Patentansprüche

1. Vorrichtung zur digitalen Amplituden- und Phasensteuerung eines Funkfrequenzsignals, mit einem variablen digitalen Dämpfungsglied und einem variablen digitalen Phasenschieber, **dadurch gekennzeichnet, dass** sie weiterhin umfasst:
- Aufteilmittel (10) mit einem Eingang (11) und zwei Ausgängen (12, 13) zum Aufteilen des Funkfrequenzsignals in einen ersten und einen zweiten Signalabschnitt,
- einen ersten digitalen Amplitudensteuerkanal (14), welcher an einen Ausgang (12) der Aufteilmittel (10) angeschlossen ist und das variable digitale Dämpfungsglied (19) enthält, um die Amplitude des ersten Signalabschnitts zu steuern;
- einen zweiten digitalen Phasensteuerkanal (15), welcher parallel zum ersten digitalen Steuerkanal (14) an den anderen Ausgang (13) der Aufteilmittel (10) angeschlossen ist und den digitalen Phasenschieber (19) enthält, um die Phase des zweiten Signalabschnitts zu steuern; und
- Rekombinationsmittel (16) mit einem Ausgang (19) und zwei Eingängen (17, 18), welche jeweils an die Ausgänge der beiden digitalen Steuerkanäle (14, 15) angeschlossen sind, um die beiden gesteuerten Signalabschnitte zu rekombinieren;
und dass die Aufteilmittel einen Verteiler (10) umfassen, um das Funkfrequenzsignal in zwei identische Signalabschnitte zu unterteilen.

2. Vorrichtung zur digitalen Steuerung nach Anspruch 1, **dadurch gekennzeichnet, dass** sie weiterhin Dämpfungsmittel (21) umfasst, welche in Serie an zumindest einen der digitalen Steuerkanäle (14, 15) angeschlossen und dazu bestimmt sind, die Abweichung zwischen den jeweiligen Einfügeverlusten des variablen digitalen Dämpfungsglieds (19) und des variablen digitalen Phasenschiebers (20) auszugleichen.

3. Vorrichtung zur digitalen Steuerung nach Anspruch 2, **dadurch gekennzeichnet, dass** die Dämpfungsmittel (21) auf dem ersten digitalen Steuerkanal (14) angeordnet und dem variablen digitalen Phasenschieber (20) vorgeschaltet sind.

4. Vorrichtung zur digitalen Steuerung nach Anspruch 2 oder 3, **dadurch gekennzeichnet, dass** die Dämpfungsmittel ein festes Dämpfungsglied (21) umfassen.

5. Linearisierungseinrichtung mit Vorverzerrung mit einem linearen Kanal (27) und einem nicht-linearen Kanal (26), welche parallel einerseits eingangsseitig an einen Eingangskoppler (22) und andererseits ausgangsseitig an einen Ausgangskoppler (23) angeschlossen sind, **dadurch gekennzeichnet, dass** sie zumindest eine digitale Steuervorrichtung (1) nach einem beliebigen der Ansprüche 1 bis 5 umfasst, welche auf einem der Kanäle (26 oder 27) der Linearisierungseinrichtung in Serie geschaltet ist.

6. Linearisierungseinrichtung mit Vorverzerrung nach Anspruch 5, **dadurch gekennzeichnet, dass** die Vorrichtung zur digitalen Steuerung (1) auf dem nicht-linearen Kanal (26) angeordnet ist.

7. Linearisierungseinrichtung mit Vorverzerrung nach Anspruch 5 oder 6, **dadurch gekennzeichnet, dass** sie weiterhin eine auf dem anderen Kanal in Serie geschaltete Verzögerungsleitung (30) umfasst.

8. Linearisierungseinrichtung mit Vorverzerrung nach Anspruch 5, **dadurch gekennzeichnet, dass** sie zwei Vorrichtungen zur digitalen Steuerung (1) nach einem beliebigen der Ansprüche 1 bis 6 umfasst, welche jeweils in Serie auf jedem Kanal der Linearisierungseinrichtung geschaltet sind, wobei eine der Vorrichtungen dazu bestimmt ist, die Gruppenzeiten der beiden Kanäle der Linearisierungseinrichtung abzugleichen.

9. Verfahren zur digitalen Amplituden- und Phasensteuerung eines Funkfrequenzsignals, **dadurch gekennzeichnet, dass** es die folgenden Schritte umfasst:
a) Aufteilen des Funkfrequenzsignals in einen ersten und einen zweiten Signalabschnitt;
b) digitales Steuern der Amplitude des ersten oder des zweiten Signalabschnitts;
c) digitales Steuern der Phase des zweiten, beziehungsweise ersten, Signalabschnitts;
d) Rekombinieren der beiden gesteuerten Signalabschnitte, um ein phasen- und amplitudengesteuertes Funkfrequenzsignal zu bilden,
und dass das Funkfrequenzsignal in zwei identische Signalabschnitte aufgeteilt ist.

10. Verfahren nach Anspruch 9, **dadurch gekennzeichnet, dass** die Schritte b) und c) gleichzeitig ausgeführt werden.

11. Verfahren nach einem beliebigen der Ansprüche 9 bis 10, **dadurch gekennzeichnet, dass** es weiterhin einen Schritt umfasst, welcher darin besteht, die während der Schritte b) und c) entstandenen Einfügeverluste auszugleichen.

12. Verfahren nach einem beliebigen der Ansprüche 9 bis 11, **dadurch gekennzeichnet, dass** das Funkfrequenzsignal ein Hyperfrequenzsignal ist.
